# EUROPEAN PATENT APPLICATION

(11) **EP 4 394 851 A1**
(43) Date of publication of application: **03.07.2024**
(21) Application number: 22217347.8
(22) Date of filing: 30.12.2022
(51) Int. Cl.: H01L 21/67, H01L 21/677

(54) **RECESS-BASED PICK AND PLACE FOR HETEROGENEOUS INTEGRATION**

(71) Applicant: ASML Netherlands B.V., 5500 AH Veldhoven (NL)
(72) Inventor: PARAYIL VENUGOPALAN, Syam, 5500 AH Veldhoven (NL); WARNAAR, Patrick, 5500 AH Veldhoven (NL); DE JAGER, Pieter, Willem, Herman, 5500 AH Veldhoven (NL); JANSEN, Bas, 5500 AH Veldhoven (NL); JANSSENS, Stef, Marten, Johan, 5500 AH Veldhoven (NL)
(74) Representative: ASML Netherlands B.V.

(57) **Abstract**

An apparatus for die placement comprising a first stage comprising a plurality of recesses, the plurality of recesses configured to accept a plurality of donor dies; a second stage comprising a support for one or more targets; and a measurement system, functionally coupled to the first stage, and configured to: obtain locations of the plurality of donor dies in the plurality of recesses of the first stage, and based at least on the obtained locations, provide output signals to adjust the locations of the plurality of donor dies supported by the first stage to correspond to locations of the one or more targets, and based at least in part on the adjusted locations, provide output signals to place the plurality of donor dies on the one or more targets supported by the second stage by relative movement between the first stage and the second stage.

## Description

### TECHNICAL FIELD

The present disclosure relates generally to a system and method for heterogeneous integration.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple die-where these specific portions which may be aligned in three-dimensional space to ensure functional connectivity. Alignment of these die, which may have multiple fabrication layers, different critical dimensions, different nodes, packaging, etc., with each other may require different techniques than use for lithography during fabrication. As the physical sizes of IC components continue to shrink, and their structures continue to become more complex, accuracy and throughput in integration become more important. For applications such as heterogeneous integration, it may be desirable to obtain both accurate and fast placement of die with respect to one another

In the context of semiconductor manufacture, improvements in die placement and alignment (e.g., improvements in heterogeneous integration) lead to improvements in IC manufacturing and integration abilities.

### SUMMARY

According to an embodiment, there is provided an apparatus for die placement comprising a first stage comprising a plurality of recesses, where the plurality of recesses are configured to accept a plurality of donor dies. The apparatus comprising a second stage, the second stage comprising a support for one or more targets. The apparatus also comprises a measurement system, which is functionally coupled to the first stage, and which is configured to obtain locations of the plurality of donor dies in the plurality of recesses of the first stage. The measurement system configured to, based at least on the obtained locations, provide output signals to adjust the locations of the plurality of donor dies supported by the first stage to correspond to locations of the one or more targets. The measurement system configured to, based at least in part on the adjusted locations, provide output signals to place the plurality of donor dies on the one or more targets supported by the second stage by relative movement between the first stage and the second stage.

In an embodiment, adjustable stages are disposed within the plurality of recesses, where the adjustable stages are configured to support the plurality of donor dies. The measurement system is further configured to provide output signals to adjust the locations of the plurality of donor dies using the adjustable stages supporting the plurality of donor dies.

In an embodiment, the measurement system further comprises an imaging device, the imaging device configured to obtain images of the plurality of donor dies in the plurality of recesses. The measurement system also comprising a processor in communication with the imaging device and configured to determine the locations of the plurality of donor dies in the plurality of recesses based on the images of the plurality of donor dies in the plurality of recesses.

In an embodiment, the apparatus further comprises a voltage source, where the measurement system is further configured to provide output signals to the voltage source. The voltage source configured to cause alignment of the plurality of donor dies and the one or more targets as the plurality of donor dies are placed on the one or more targets by relative movement between the first stage and the second stage.

According to another embodiment, there is provided a method for die placement comprising placing a plurality of donor dies into a plurality of recesses in a first stage, where the first stage is in a first position relative to a second stage. The method comprising measuring locations of the plurality of donor dies in the plurality of recesses. The method comprising adjusting the locations of the plurality of donor dies within the plurality of recesses to correspond to a plurality of target locations, where the plurality of target locations corresponding to a second stage. The method comprising placing the plurality of donor dies onto the plurality of target locations, where the first stage is in a second position relative to the second stage, and where the first position is different than the second position.

According to an embodiment, a die placement tool configured to perform the method of any other embodiment is provided.

According to another embodiment, one or more non-transitory, machine-readable medium is provided having instructions thereon, the instructions when executed by a processor being configured to perform the method of any other embodiment.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figures 1A-1D are schematic diagrams illustrating an exemplary die bonding method, according to an embodiment.
Figure 2 is a schematic diagram illustrating a method of placement of dies by a moveable stage with recesses, according to an embodiment.
Figure 3 is a schematic diagram illustrating a method of placement of heterogeneous die integration, according to an embodiment.
Figure 4 is a flowchart which illustrates a method of die placement, according to an embodiment.
Figures 5A-5B are schematic diagrams illustrating a method of placement of dies in recesses of a moveable stage, according to an embodiment.
Figures 6A-6B are schematic diagrams illustrating a method of adjusting placement of dies in recesses of a moveable stage, according to an embodiment.
Figures 7A-7C are schematic diagrams illustrating a method of placement of dies onto targets by use of recesses in a moveable stage, according to an embodiment.
Figure 8 is a flowchart which illustrates a method of die adjustment, according to an embodiment.
Figure 9 is a schematic diagram illustrating a method of die location measurement using two-dimensional images, according to an embodiment.
Figures 10A-10B are schematic diagrams illustrating a method of die location measurement using one-dimensional images, according to an embodiment.
Figure 11 is a flowchart which illustrates a method of die location determination, according to an embodiment.
Figure 12 is a block diagram of an example computer system, according to an embodiment of the present disclosure.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer"-that is a "die" may be produced by dicing or otherwise dividing a "wafer". The term "die" should be considered as interchangeable with the term chip, chiplet, or other terms for IC divisions. A patterning device (for example, a lithography device) can comprise, or can form, one or more patterns, which may correspond to one or more die. The patterns can be generated utilizing CAD (computer-aided design) programs, based on a pattern or design layout, this process often being referred to as EDA (electronic design automation). As used throughout this application "or", unless indicated otherwise, takes a non-exclusive meaning, e.g., encompassing both "and" and "or".

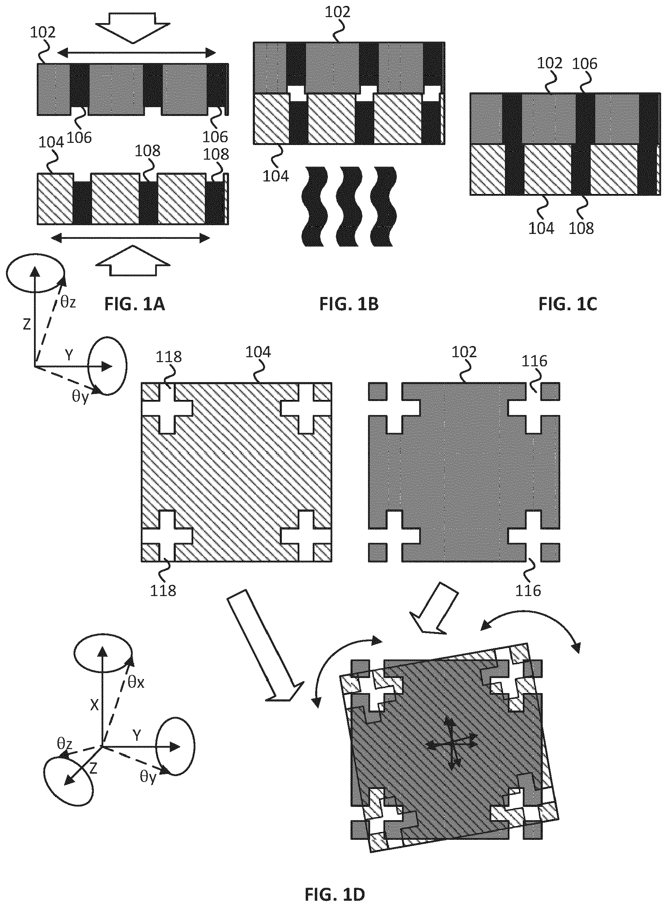

Reference is now made to Figures 1A-1D, which are schematic diagrams illustrating an exemplary die bonding method consistent with embodiments of the present disclosure. The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "donor" are provided for reference and are relative and that elements described as corresponding to a "donor" can instead correspond to a "target" and vice versa. The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

As shown in Figure 1A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. The alignment may be complicated by the multiple layers of the donor die 102 or the multiple layers of the target die 104, which may be optically opaque. Figures 1A-1C depict a cross-sectional view of portions of the exemplary die bonding method.

As further shown in Figure 1A, the donor die 102 and the target die 104 may be brought together along the z-axis, while the position of the donor die 102 or the target die 104 may be adjusted in the x-y plane (e.g., perpendicular to the z-axis of approach). As shown in Figure 1B, the donor die 102 and the target die 104 may be annealed after contact. Annealing may be or include heat annealing, electrical annealing, electrostatic processes, van der Waals processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 in the electrically active areas 108. Annealing may therefore produce electrical connectivity between elements of the donor die 102 and the target die 104 (e.g., integration). This electrical connectivity may occur even if the electrically active areas 106 and the electrically active areas 108 differ-for example, have different recessed depths, are made up of different materials, have different dimensions, etc.

Figure 1D depicts a plan view of an example die bonding method according to this disclosure. As shown in Figure 1D, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or substractively fabricated, such as by etching or deposition in the z-direction. Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method-for example, scribing and breaking, mechanical sawing, laser cutting, etc.-and may destroy (e.g., grind to powder or otherwise render inoperable for circuitry placement) a non-zero linewidth portion of the wafer volume when separating die. Alternatively, the electrically active areas 106 of the donor die 102 or the electrically active areas 108 of the target die 104 (not shown in Figure 1D) or other surface features may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the X axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes-e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

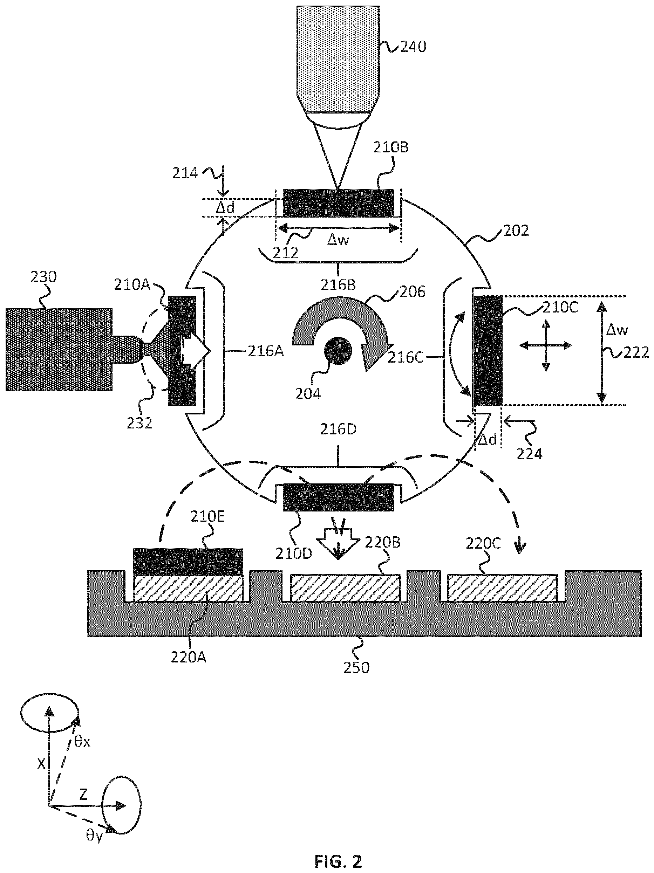

Figure 2 is a schematic diagram illustrating a method of placement of donor dies by a moveable stage with recesses. Figure 2 is described with reference to "donor die" and "target die", which are relative descriptors and donor die may instead be target die and vice versa. Figure 2 is a cross-sectional view of placement of donor die 210A-210E using support stage 202. The support stage 202 is substantially circular in the x-z plane, with a longitudinal axis 204 along the y-direction (e.g., the support stage 202 is substantially cylindrical in three dimensions). The support stage 202 may instead have a different cross-sectional shape, such as square, hexagonal, etc. The support stage 202 may have a symmetrical (e.g., as shown) cross-section with one or more axis of symmetry, or asymmetrical cross-sectional area (for example, an irregular polygon).

The support stage 202 has recesses 216A-216D with a recess depth 214 and a recess width 212. The recesses may also have a recess length in the y-direction (not shown). The recesses 216A-216D are depicted as having substantially similar dimensions, but the recesses 216A-216D may instead have variable recess depth 214 (for example, different recess depth 214 for recess 216A and recess 216B) or variable recess width 212 (for example, different recess width for recess 216C and recess 216D) or variable recess length (for example, different recess length for recess 216B and recess 216D). The placement of the recesses 216A-216D may be symmetrical or asymmetrical around the cross-sectional area of the support stage 202. The support stage 202 may have a substantially symmetrical cross section but have asymmetric placement of recesses. For example, the support stage 202 may have a cross-section that is a regular hexagon but have recesses placed asymmetrically along longitudinal faces.

The recesses 216A-216D are capable of accepting donor dies, such as the donor die 210A-210E. The donor dies 210A-210E with a die depth 224 and a die width 222. The donor die 210A-210E may also have a die length in the y-direction (not shown). The donor die 210A-210E are depicted as having substantially similar dimensions, but the donor die 210A-210E may instead have variable die depth 224 (for example, different die depth 224 for recess 216A and recess 216B) or variable recess die width 222 (for example, different die width for recess 216C and recess 216D) or variable recess length (for example, different die length for recess 216B and recess 216D). The die width 222 may be smaller than the recess width 212. The die depth 224 may be smaller than, larger than, or substantially the same as the recess depth 214. That is, the donor die 210A-210E, when occupying the recesses 216A-216D, may sit substantially recessed from a surface of the support stage 202, substantially flush with the surface of the support stage 202, or protrude from a surface of the support stage 202.

The support stage 202 may be controllably moved in a direction 206 about the longitudinal axis 204. The direction 206 is provided as an example. The support stage 202 may instead be rotated in an opposite direction or any appropriate direction, translated along the x, y, or z direction or any combination thereof. The support stage 202 may be operated in both rotational and a translational modes, including sequentially or at the same time. For example, the support stage 202 may move in the negative x-direction towards a support structure 250 while also rotating about the longitudinal axis 204. The support stage 202 may move continuously or intermittently. For example, the support stage 202 may rotate in the direction 206 and stop at four (or fewer or more) positions corresponding to operations in the placement of die. Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the support stage 202 is substantially zero), but the positions may instead correspond to continuous (or quasi-continuous movement) or operations may occur while the support stage 202 is moving in one or more directions (e.g., rotationally, translationally, etc.).

A first position, such as corresponding to the position depicted for the donor die 210A, may correspond to placement of die in recesses (e.g., in the recess 216A) of the support stage 202. The donor die 210A may be placed in the recess 216A by a pick and place element 230. The pick and place element 230 may place the donor die 210A on the support stage 202 in the recess 216A based on alignment information (for example, based on detection of the positions of the recess 216A), based on positional information of the support stage 202 (for example, based on detection that the support stage 202 is at the first position), etc. The pick and place element 230 may place the donor die 210A on the support structure with at a given position relative to the recess 216A. For example, the pick and place element 230 may center the donor die 210A within the recess 216A. The pick and place element 230 may have intrinsic error or inaccuracy.

The placement of the donor die 210A within the recess 216A may have an intended position (for example, centered in the recess 216A) and an actual position, where the actual position may differ from the intended position based on limitation of the pick and place element 230. The intended position may be a position that is not in the center of the recess 216A. The intended position may be identified in two directions (e.g., in the x-z place for the donor die 210A as depicted). The intended position may be identified in three directions (e.g., in x-y-x space for the donor die 210A as depicted). The intended position may be identified in up to six directions (or degrees of freedom), such as with respect to position in x-y-z space and with respect to rotation along each of the x-y-z axes (in free space). The intended position may be identified with respect to any appropriate dimensions or directions. The actual position (e.g., of the donor die 210A) may likewise be described by any appropriate dimension or directions, such as those described in reference to the intended position. The difference between the intended position and the actual position will be further described in reference to a second position (e.g., the position of the donor die 210B and the recess 216B).

The difference between the intended position and the actual position may be bounded by the difference between the size of the recess 216A and the size of the die 210A. For example, the pick and place element 230 may attempt to place the donor die 210A within the recess 216A. If the pick and place element 230 does not place the donor die 210A within the recess 216A, which may occur if the donor die 210A is misaligned with the recess 216A (such as if the donor die 210A connects with a portion of the unrecessed portion of the support stage 202), the pick and place element 230 may detect that the donor die 210A is not placed within the recess 216A (for example, based on detection of a distance in the z-direction) or is only partially placed within the recess 216A (for example, based on detection of an angle of the donor die 210A with respect to the z direction). If the pick and place element 230 does not place the donor die 210A within the recess 216A (or detects that the donor die 210A is not placed within the recess 216A), the pick and place element 230 may remove the donor die 210A and may subsequently attempt to replace the donor die 210A (or another die) in the recess 216A. The pick and place element 230 may also or instead leave the recess 216A empty if the donor die 210A is not successfully placed in the recess 216A.

The pick and place element 230 may adhere an end effector (such as a conical suction end effector indicated by the dashed ellipse 232) to one or more surfaces of the donor die 210A. Other end effector configurations and methods of donor die 210A placement may be used, such as clamping, hydraulic, electrostatic, capacitive, and other types of adhesion. The pick and place element 230 may move the donor die 210A from a pick up location (for example, a chip storage location) to a release location, which may be the recess 216A. The pick and place element may move the donor die 210A in one or more direction. The pick and place element 230 may be a chip shooter. The pick and place element 230 may adhere to the donor die 210A electrostatically, through use of suction, via hydraulic effects, through capacitive attraction, etc. The pick and place element 230 may interact with the donor die 210A via an end effector, which may controllably hold and release the donor die 210A.

Once the donor die 210A is placed in the recess 216A, the support stage 202 may move (e.g., in the direction 206), so that the donor die 210A occupies the position of the donor die 210B. and so that the recess 216A occupies the position of the recess 216B-which may be the second position of the support structure. The second position of the support structure will now be described with reference to the donor die 210B and the recess 216B, which it should be understood may be the donor die 210A and the recess 216A after movement of the support structure from the first position to the second position.

The second position, such as corresponding to the position depicted for the donor die 210B, may correspond to measurement of the position of the die in recesses (e.g., of the donor die 210B in the recess 216B) of the support stage 202. The position (e.g., location) of the donor die 210B may be measured by a location measurement element 240. The location measurement element 240 may measure an actual position of the donor die 210B, in relative (such as relative to edges of the recess 216B) or absolute terms (such as in distances from an origin point on the support stage 202, on the location measurement element 240, etc.). The location measurement element 240 may measure an intended position of the donor die 210B, such as by measuring extends of the recess 216B. The location measurement element 240 may be a camera, e.g., a two-dimensional camera, two or more one-dimensional cameras, an optical camera, etc., or another measurement device. The location measurement element 240 may be made up of multiple location measurement elements, such as an in-plane measurement device which may measure locations in the y-z plane (relative to the refence axes) and an out of plane measurement device which may measure locations or distances in the x direction (relative to the reference axes). The location measurement element 240 may include one or more confocal microscopes, which may measure depth (or other distance). The location measurement element 240 may measure position, relative or absolute position, using overlay diffraction or other diffraction-based methods. The location measurement element 240 may operate in a scanning mode or from a fixed position relative to the support stage 202.

Once the position of the donor die 210B in the recess 216B is measured, the support stage 202 may move (e.g., in the direction 206), so that the donor die 210B occupies the position of the donor die 210C, and so that the recess 216B occupies the position of the recess 216C-which may be a third position of the support stage 202. The third position of the support structure will now be described with reference to the donor die 210C and the recess 216C, which it should be understood may be the donor die 210A and the recess 216A after movement of the support structure from the first position to the third position or, likewise, the donor die 210B and the recess 216B after movement of the support structure from the second position to the third position.

The third position, such as corresponding to the position depicted for the donor die 210C, may correspond to adjustment of the position of the die in recesses (e.g., of the donor die 210C in the recess 216C) of the support stage 202. The position of the donor die 210C may be adjusted based on the measured position of the donor die 210C, such as obtained when the support structure is in the second position. The position of the donor die 210C may be adjusted based on a relationship (such as a difference) between the intended position and the actual position of the donor die 210C. The position of the donor die 210C may be adjusted by a die actuator (not shown). Die actuator herein is used to refer to a structure comprising a die chuck or other die receptacle and one or more controllable actuator which may adjust a position of a die in at least one direction. The die actuator may adjust a position of the die (e.g., the donor die 210C) in one or more directions, sequentially or at the same time. The die actuator may be composed of multiple die actuators or operable in multiple directions, such as in-plane (e.g., along the x-y plane for the donor die 210C), out of plane (along the z-direction for the donor die 210C), with respect to three dimensions, with respect to four degrees of freedom (such as with respect to the in-plane direction and with respect to angles of rotation along the in-plane axes), with respect to six degrees of freedom (such as with respect to the x-y-z space and with respect to the angles of rotation along each of the orthogonal axes), etc. The die actuator may be integrated into the support stage 202 or separate elements along the bottom or sides of the recesses 210A-210D of the support structure. The die actuator may be attached to the die (e.g., the donor die 210C) before it is placed into the recess 216C (e.g., at the first position). Each recess or die may have one or more die actuators.

The die actuators may be devices capable of supporting one or more die (e.g., donor die 210C). The die actuators may support die on one or more die chuck or other support structure. The die actuators may electrostatically or otherwise secure the die to the one or more die chuck or other support structure. The die actuators may have one or more adjustable elements (e.g., strut) which may be activated to adjust a position of the die. The die actuators may be electrically controllable. The die actuators may be reusable-that is, the die actuators may adhere and release the donor die 210C (such as adhere the donor die 210C at the first position and release the donor die 210C at a fourth position to be subsequently described). The die actuators may include piezoelectric elements. The die actuators may include spring elements. The die actuators may include dynamic (e.g., sliding, bending, rolling, etc.) elements which may allow for self-alignment of die with target locations. Other methods of self-alignment may be used, including methods described in European Patent Application EP 22196903.3, which is herein incorporated by reference in its entirety.

The position of the donor die 210C may be adjusted to correspond to the intended position. That is, the actual position of the donor die 210C may be adjusted to correspond to an intended position, which may be predetermined such as based on the dimensions of the recess 216C. The position of the donor die 210C may be adjusted to correspond to a target location, such as a location to which the donor die 210C is to be adhered. The target location may be obtained from storage, such as based on a theoretical target (e.g., a target design), obtained by measurement, such as based on a fabricated target, etc. Adjustment of the position of the donor die 210C to correspond to a target location may be different from adjustment of the position of the donor die 210C to correspond to an intended location. For example, the intended location of the donor die 210C may be the center of the recess 216C. However, if measurement of the target location (e.g., the location on to which the donor die 210C is to be place) indicates that the target location is, for example, offset in the x-direction, the adjustment of the position of the donor die 210C to correspond to the target location may account for (for example, be offset by a complementary amount) in the x-direction. That is, the intended location may be a location uninformed by information about a specific target location (e.g., the same for all die regardless of corresponding target), or may be further informed by information about a specific target location.

Once the position of the donor die 210C in the recess 216C is adjusted, the support stage 202 may move (e.g., in the direction 206), so that the donor die 210C occupies the position of the donor die 210D and so that the recess 216C occupies the position of the recess 216D-which may be the fourth position of the support stage 202. The fourth position of the support structure will now be described with reference to the donor die 210D and the recess 216D, which it should be understood may be the donor die 210A and the recess 216A after movement of the support structure from the first position to the fourth position, the donor die 210B and the recess 216B after movement of the support structure from the second position to the fourth position, or, likewise, the donor die 210C and the recess 216C after movement of the support structure from the third position to the fourth position.

The fourth position, such as corresponding to the position depicted for the donor die 210D, may correspond to placement of the die (e.g., of the donor die 210D in the recess 216D of the support stage 202) on a corresponding target-for example, a target die 220B. The target die 220B may be one of a set of target die 220A-220B which may be sequentially contacted by donor die (e.g., donor die 210A-210E) during various movements of the support stage 202. The target die 220A-220B may be the same as or different from the donor die 210A-210E. For example, the target die 220A-220B may be of the same or different circuitry type or orientation as the donor die 210A-210E (that is, of the same node, logic vs. memory, etc.). The target die 220A-220B may be of the same or different dimensions than the donor die 210A-210E. That is, the donor die 210E may be of the same, larger, or smaller dimensions in the y-z plane as the target die 220A. Likewise, the donor die 210E may be of the same, larger, or smaller thickness in the x-direction as the target die 220A. The target die 220A-220C are depicted as the same type of target die, but may instead be different types of die.

The target die 220A-220C are supported by the support structure 250, where each of the target die 220A-220C lies within a recess. The target die 220A-220C may instead lie on an un-recessed support structure. In one embodiment, the target die 220A-220C may not be a die (that is may not be diced). The target die 220A-220C may instead be a target location (which may or may not correspond to areas intended to later become dies) in an undiced wafer, for example.

The donor die 210D may be placed on the target die 220B by motion of the support stage 202 towards the target die 220B. Alternatively or additionally, the support structure 250 may also be a moveable structure operable to bring the donor die 210D and the target die 220B into contact. The donor die 210D and the target die 220B may experience self-alignment as the donor die 210D and the target die 220B approach one another. For example, the donor die 210D and the target die 220B may be electrically biased such that electrically active areas of the donor die 210D (e.g., electrically active areas 106 of Figures 1A-1C) align via electrical attraction and repulsion with electrically active areas of the target die 220B (e.g., electrically active areas 108 of Figures 1A-1C).

Once the donor die 210D is placed on the target die 220B, the support stage 202 and the support structure 250 may operate (individually or in concert) to place additional donor die on additional target die. For example, the support structure 250 may move in the negative z-direction so that the target die 220C is proximate to the support stage 202 and a donor die (for example, the donor die 210C after rotation of the support stage 202) may be placed on the target die 220C. The relative motion of the support stage 202 and the support structure 250 may occur in any appropriate direction. A direction of gravity is not depicted, but the placement of the donor die 210D on the target die 220B may experience gravitation effects. For example, the placement of the donor die 210D on the target die 220B may be encouraged by gravity (e.g., occur in the direction of gravity) or be retarded by gravity (e.g., occur opposite the direction of gravity). Gravitational effects may be balanced by die clamps, suction, vacuum, and other forces.

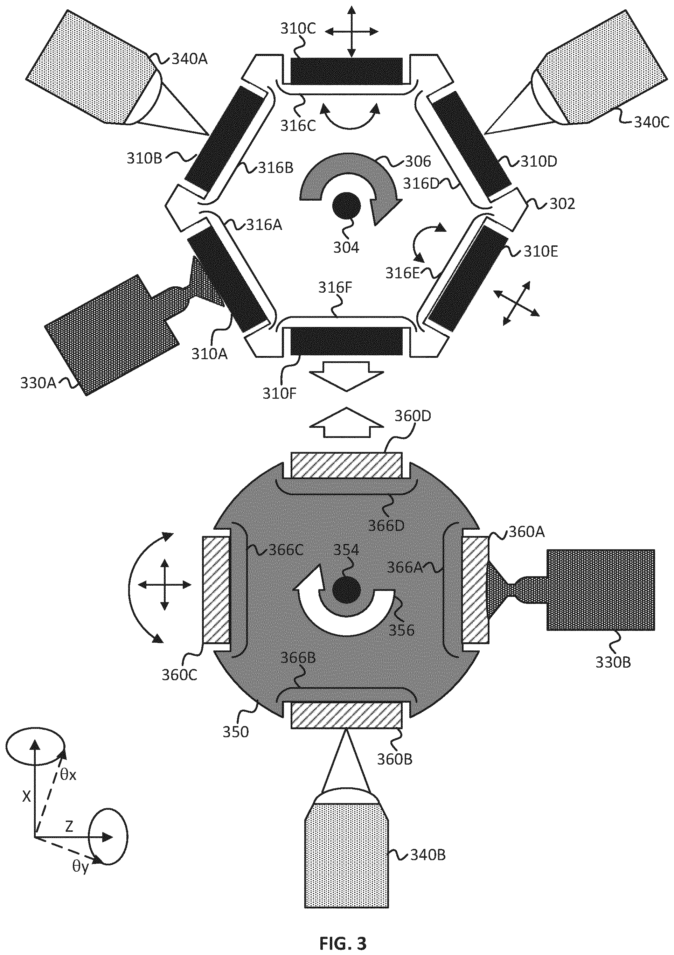

Figure 3 is a schematic diagram illustrating a method of placement of heterogeneous die integration. Figure 3 is described with reference to "donor die" and "target die" for ease of description. Such descriptors herein are relative descriptors and donor die may instead be target die and vice versa, and both donor die and target die may instead be considered "donor die". Figure 3 is a cross-sectional view of placement of donor die 310A-310F supported by first support stage 302 on target die 360A-360D on second support stage 350. The first support stage 302 is substantially hexagonal in the x-z plane, with a longitudinal axis 304 along the y-direction. The first support stage 302 may instead have a different cross-sectional shape, such as round, square, hexagonal, etc. The second support stage 350 is substantially circular in the x-z plane, with a longitudinal axis 354 along the y-direction. The second support stage 350 may instead have a different cross-sectional shape, such as square, hexagonal, etc. The second support stage 350 may have a symmetrical (e.g., as shown) cross-section with one or more axis of symmetry, or asymmetrical cross-sectional area (for example, an irregular polygon. The first support stage 302 may have the same (not shown) or different cross-sectional area, length (e.g., in the y-direction) or different (e.g., as depicted) as the second support stage 350.

The first support stage 302 has recesses 316A-316F while the second support stage 350 has recesses 366A-366D. The recesses 316A-316F may have the same or different recess dimensions (e.g., recess width, recess depth, recess length) as described in reference to the recesses 216A-216D of Figure 2. Likewise, the recesses 366A-366D may have the same of different recess dimensions (e.g., recess width, recess depth, recess length) as previously described. The recesses 316A-316F may have the same or different dimensions as the recesses 366A-366D. The recesses 316A-316F and the recesses 366A-366D may correspond to a single die (e.g., one of the donor die 310A-310F or the target die 360A-360D, respectively). In one embodiment, the recesses 316A-316F or the recesses 360A-360D may have multiple dimensions (e.g., recess width, recess depth, recess length) such as corresponding to multiple die. For example, the recess 316A may have a first recess depth, first recess width, or first recess length which corresponds to a first donor die and a second recess depth, second recess width, or second recess length which corresponds to a second donor die-that is, the recess 316A may support multiple die with the same or different dimensions.

The placement of the recesses 316A-316F may be symmetrical or asymmetrical. The placement of the recesses 366A-366D may be symmetrical or asymmetrical. The separation of the recesses 316A-316F (e.g., in angle, in distance along the outer radius of the cross-sectional area) and separation of the recesses 360A-360D may be the same or different.

The first support stage 302 may be controllably moved in a direction 306 about the longitudinal axis 304. The second support stage 350 may be controllably moved in a direction 356 about the longitudinal axis 354. The directions 306 and 356 are provided as an example, as described previously in reference to the direction 206 of Figure 2. The first support stage 302 and the second support stage 350 may move in any appropriate direction and at any appropriate speed (for example, continuously or intermittently) as previously described. The first support stage 302 and the second support stage 350 may move in the same direction, in different direction, at the same speed, at different speeds, etc.

Example positions and operations will now be further discussed in reference to Figure 3, based on the example positions and operations previously described in Figure 2. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the first support stage 302 and the second support stage 350 is substantially zero), but the positions may instead correspond to continuous (or quasi-continuous movement) or operations may occur while the first support stage 302 or second support stage 350 is moving in one or more directions (e.g., rotationally, translationally, etc.).

A first position of the first support stage 302, such as corresponding to the position depicted for the donor die 310A, may correspond to placement of die in recesses (e.g., of the donor die 310A in the recess 316A by a pick and place element 330A) of the first support stage 302. A first position of the second support stage 350, such as corresponding to the position depicted for the target die 360A, may correspond to placement of die in recesses (e.g., of the target die 360A in the recess 366A by a pick and place element 330B) of the second support stage 350. The placement of the die in recesses may occur by any appropriate method, such as those described in reference to Figure 2.

A second position of the first support stage 302, such as corresponding to the position depicted for the donor die 310B, may correspond to measurement of the position of the die in recesses (e.g., of the donor die 310B in the recess 316B by a location measurement element 340A) of the first support stage 302. A second position of the second support stage 350, such as corresponding to the position for the target die 360B, may correspond to measurement of the position of the die in recesses (e.g., of the target die 360B in the recess 366B by a location measurement element 340C) of the second support stage 350. The measurement of the die in recesses may occur by any appropriate method, such as those described in reference to Figure 2.

A third position of the first support stage 302, such as corresponding to the position depicted for the donor die 310C, may correspond to adjustment of the position of the die in recesses (e.g., of the donor die 310C in the recess 316C) of the first support stage 302. A third position of the second support stage 350, such as corresponding to the position depicted for the target die 360C, may correspond to adjustment of the position of the die in recesses (e.g., of the target die 360C in the recess 366C) of the second support stage 350. The adjustment of the die in recesses may occur by any appropriate method, including by use of die actuators, as described in reference to Figure 2.

A fourth position of the first support stage 302, such as corresponding to the position depicted for the donor die 310D, may correspond to measurement of the position of the die in recesses (e.g., of the donor die 310D in the recess 316D by a location measurement element 340C) of the first support stage 302. One or more additional measurements of the position of the die in recesses may occur, such as for use in iterative or incremental positional adjustment. The location measurement element 340C may be the same as or different from the location measurement element 340A. The location measurement element 340C may acquire the same or different positional information as the location measurement element 340A. For example, the location measurement element 340A may acquire positional information (e.g., actual position) of a die (e.g., of the die 310B in the recess 316B) in an out of plane direction (e.g., perpendicular to the longitudinal plane of the recess 316B). The location measurement element 340C may then acquire positional information (e.g., actual position) of a die (e.g., of the die 310D in the recess 316D) in an in-plane direction (e.g., in the longitudinal plane of the recess 316D). In another example, the location measurement element 340A may acquire gross positional information (e.g., actual position) of a die (e.g., of the die 310B in the recess 316B), while the location measurement element 340C may acquire fine positional information (e.g., actual position) of a die (e.g., of the die 310D in the recess 316D). In yet another example, the location measurement element 340A may acquire the same positional information (e.g., actual position) of a die (e.g., of the die 310B in the recess 316B) as the location measurement element 340C acquires, such as positional information (e.g., actual position) of a die (e.g., of the die 310D in the recess 316D). The measurement of the die in recesses may occur by any appropriate method, such as those described in reference to Figure 2.

A fifth position of the first support stage 302, such as corresponding to the position depicted for the donor die 310E. may correspond to adjustment of the position of the die in recesses (e.g., of the donor die 310E in the recess 316E) of the first support stage 302. One or more additional adjustments of the position of the die in recesses may occur, such as in iterative or incremental positional adjustment. The adjustment occurring at the fifth position may be the same as or different from the adjustment occurring at the second position described above. For example, the adjustment occurring at the fifth position may occur by operation of a die actuator, which may be the same or a different die actuator that is used to perform the adjustment occurring at the second position. The die actuator operated at the third position (e.g., for adjustment of the die 310C in the recess 316C) and the die actuator operated at the fifth position (e.g., for adjustment of the die 310E in the recess 316E) may correspond to the same or different components of a die actuator (for example, a global die actuator containing multiple subunits).

The adjustment occurring at the fifth position may occur based on the same of different positional information, such as the actual position acquired at the fourth position or the actual position acquired at the second position (as depicted). In another example, the location measurement element 340A may acquire positional information (e.g., actual position) of a die (e.g., of the die 310B in the recess 316B) in an out of plane direction (e.g., perpendicular to the longitudinal plane of the recess 316B) and the die (e.g., the die 310C in the recess 316C) may be adjusted in the out of plane direction at the second position. The location measurement element 340C may then acquire positional information (e.g., actual position) of a die (e.g., of the donor die 310D in the recess 316D) in an in-plane direction (e.g., in the longitudinal plane of the recess 316D) and the die (e.g., the donor die 310E in the recess 316E) may be adjusted in the in plane direction at the fifth position. In yet another example, the location measurement element 340A may acquire gross positional information (e.g., actual position) of a die (e.g., of the die 310B in the recess 316B) and the die (e.g., the die 310C in the recess 316C) may be adjusted based on the gross positional information, while the location measurement element 340C may acquire fine positional information (e.g., actual position) of a die (e.g., of the die 310D in the recess 316D) and the die (e.g., the die 310E in the recess 316E) may be adjusted based on the fine positional information. In an example, the location measurement element 340A may acquire the same type of positional information (e.g., actual position) of a die (e.g., of the die 310B in the recess 316B) as the location measurement element 340C acquires, such as positional information (e.g., actual position) of a die (e.g., of the die 310D in the recess 316D), and the position of the die (e.g., of the die 310C in the recess 316C or the die 310E in the recess 316E) may be iteratively adjusted. The adjustment of the die in recesses may occur by any appropriate method, such as those described in reference to Figure 2 or with respect to the second position of the first support stage 302.

While the fourth and fifth positions are depicted with respect to the first support stage 302, multiple measurement and adjustment of die operations may be performed (including at discrete location) for any of the die and support stages described herein. Multiple measurement and adjustment operations may be performed at specific locations, such as depicted for the first support stage 302. Additional measurement and adjustment operations may also be performed at a given location. Additional measurement and adjustment operations may be performed as a matter of course, as needed (such as if measurements indicate that the actual position of a die falls outside a threshold), etc. Additional measurement and adjustment operations may be performed at the same location, including by moving of or returning the die to a previous measurement or adjustment location. For example, the second support stage may operate in reverse (e.g., turn in a direction opposite to the direction 356) in order to bring one or more die back to the location measurement element 340B for additional measurement.

A sixth position of the first support stage 302, such as corresponding to the position depicted for the donor die 310F, may correspond to placement of the die (e.g., of the donor die 310F in the recess 316F) of the first support stage 302 on a corresponding target die (e.g., the target die 360D in the recess 366D of the second support stage 350). A fourth position of the second support stage 350, such as corresponding to the position depicted for the target die 360D, may correspond to placement on or joining of the die (e.g., of the target die 360D in the recess 366D of the second support stage 350) to a corresponding donor die (e.g., the donor die 310F in the recess 316F of the first support stage 302). The placement of the die upon each other may occur by any appropriate method as described in reference to Figure 2. The placement of the die upon each other may be supported by either the first support stage 302 or the second support stage 350-e.g., the joined die may be supported by either the first support stage 302, the second support stage 350, or may be released from both the first support stage 302 and the second support stage 350 (not depicted). The joined dies may be supported by a recess in a support stage and removed from the support stage at an additional position (not depicted). The joining of the die may include self-alignment operations. The joining of the die may include annealing operations. The joining of the die may include electrical operations, including electrical testing.

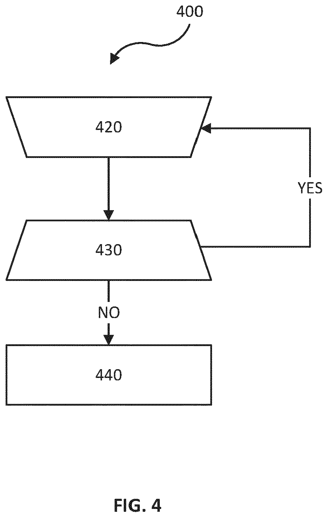

Figure 4 is a flowchart which illustrates a method of die placement. Each of these operations is described in detail below. The operations of method 400 presented below are intended to be illustrative. In some embodiments, method 400 may be accomplished with one or more additional operations not described, and/or without one or more of the operations discussed. Additionally, the order in which the operations of method 400 are illustrated in Figure 4 and described below is not intended to be limiting. In some embodiments, one or more portions of method 400 may be implemented (e.g., by simulation, modeling, etc.) in one or more processing devices (e.g., one or more processors). The one or more processing devices may include one or more devices executing some or all of the operations of method 400 in response to instructions stored electronically on an electronic storage medium. The one or more processing devices may include one or more devices configured through hardware, firmware, and/or software to be specifically designed for execution of one or more of the operations of method 400, for example.

At an operation 420, a plurality of donor die locations are obtained. The donor die locations may be obtained via measurement of one or more positions of the donor dies along one or more dimension. The locations of the plurality of donor dies may be measured in-plane (e.g., in the x-y plane) via a first method and measured out of plane (e.g., in the Z direction) via a second method. For example, the locations of the plurality of donor die may be measured based on one or more images in-plane. The locations of the plurality of donor die may be obtained from a two-dimensional image, which may show locations of the edges or corners of the donor die with respect to positions on a support structure or on die actuators. The locations of the plurality of donor die may be obtained based on features (for example electrically active areas) on an exposed surface of the donor die. These features of the donor die may be used as alignment marks or reference marks. In some embodiments, alignment marks may be included as exposed features of the donor die. The alignment marks may be specifically added for die bonding or may be alignment marks corresponding to previous fabrication steps.

The plurality of donor die location may be obtained for the plurality of donor dies, where the plurality of donor dies are within recesses of a first stage (e.g., a support stage). The plurality of donor die locations may be obtained with respect to features of the recesses, such as sidewalls, corners, etc. The plurality of donor die locations may be obtained with respect to the first stage or an origin point on the first stage. The plurality of donor die locations may be obtained with respect to an intended position. The intended position may be a position at which the plurality of donor dies are to be placed within the recesses of the first stage.

Obtaining the plurality of donor die locations may occur at a given position of the first stage, such as a position where the plurality of recesses which contain one or more of the plurality of donor die are accessible by a location measurement element. Obtaining the plurality of donor die locations may occur after the plurality of donor die are placed within recesses of the first stage, such as by a pick and place element. Obtaining the plurality of donor die locations may occur at a given position of the first stage to which the first stage is moved after the plurality of donor die are placed in the recesses, such as by the pick and place element. Placing of the plurality of donor die within the plurality of recesses may occur at a first position of the first stage, while measure of the plurality of donor die location may occur at a second position of the first stage, where it should be understood that "first" and "second" are relative identifiers and not absolute descriptions of positions.

At an operation 430, the locations of the plurality of donor die are adjusted. Adjusted includes cases in which locations are minimally or substantially not adjusted after measurement, such as if a measured location corresponds to the target location within a threshold. The locations of the plurality of donor die may be adjusted by action of die actuators. The die actuator may adjust a position of the donor dies in one or more direction. The die actuator may adjust a length, position, angle of one or more support (e.g., a strut) which supports a donor die chuck or other donor die support. The die actuators may be controlled, including electrically controlled, by one or more measurement systems, such as a measurement system which incorporates a location measurement element. The die actuators may be controlled by a system, such as the one or more measurement systems, which also controls a pick and place element. Adjustment of the locations of the plurality of donor die may correspond to adjustment of one or more donor die chuck. Adjustment of the locations of the plurality of donor die may correspond to adjustment of locations of one or more donor die actuators. Adjustment of the locations of the plurality of donor die may include iterative measurement of the plurality of donor die locations, including as adjustment occurs.

Adjustment of the locations of the plurality of donor die locations may occur at a given position of the first stage, such as a position where the plurality of recesses with contain one or more of the plurality of donor die are accessible by die actuators. Adjustment of the position of the plurality of donor die locations may occur after the locations of the plurality of donor die are obtained, such as by a location measurement element. Adjusting the plurality of donor die locations may occur at a given position of the first stage to which the first stage is moved after the plurality of donor die are placed in the recesses, such as by the pick and place element, and after the plurality of donor die locations are measured, such as by a location measurement element. Adjustment of the locations of the plurality of donor die within the plurality of recesses may occur at a third position of the first stage, while measurement of the plurality of donor die location may occur at a second position of the first stage and placing of the plurality of donor die within the recesses may occur at a first position of the first stage, where again "first", "second", and "third" are relative descriptors.

Adjustment of the locations of the plurality of donor dies may occur based on targets of the donor die. The targets may be target locations. Targets (e.g., target locations) may be obtained. The targets may correspond to locations of a plurality of target die. The targets may correspond to a plurality of locations on a target wafer. The targets may be positions (e.g., positions in three dimensions such as along X, Y, and Z axes, physicians in six directions such as along X, Y, and Z axes and with respect to angles of rotation about those axes, etc.). The targets may be sets of positions, for example 2 or more positions of or on targets (such as electrically active areas like electrically active areas 108 of Figure 1A) to which areas of the donor die are to be bonded.

The targets may be obtained from target patterns, e.g., from plans of the targets. The target locations may be obtained for measurement, for example from measurement of fabricated target dies, target wafers, etc. The targets may be obtained in any appropriate coordinate system, such as relative to one or more alignment marks on a target wafer, on die actuators, on a support structure, etc.

In some embodiments, the targets may be used to inform the pick and place element when placing the plurality of donor die. In some embodiments the plurality of donor die may be placed in the recesses based on the obtained plurality of target locations. That is, the targets may be used to inform the pick and place element when placing the plurality of donor die.

Adjustment of the locations of the plurality of donor die may include adjustment of the plurality of donor die to locations corresponding to targets of the donor die, which may not be identical to the locations of the target die. That is, locations corresponding to the targets may be locations which correspond to but are not equal to target locations. For example, the locations corresponding to the targets of the donor die may be locations with are at the limits of adjustment of the donor die, such as for targets which lie outside an adjustment range of the donor die. Alternatively, if a target lies outside the extents of donor die adjustment, the donor die may not be placed on the location corresponding to the target, such as if it is determined that bonding would not be possible based on the target and the locations corresponding to the target. The locations corresponding to the targets may be an approximation of target locations, such as to within a measurement precision. The locations corresponding to the targets may be intermediate locations (such as during iterative adjustment of the locations of the plurality of donor dies), placement locations (such as locations between the locations of the plurality of donor dies and the target locations), etc.

For example, the plurality of donor die and the one or more targets may be used to determine placement locations, such as a placement location for each of the plurality of donor die and a corresponding target, to which both the donor die and corresponding target may be adjusted. A donor die location and a target die location may be obtained (e.g., measured) and a placement location may be determined, where the placement location is a location to which both the donor die and target may be adjusted. For example, if a donor die is offset (such as from a recess) by 4 µm in first direction (e.g., from an intended position) and a target die is offset (such as from a recess) by 1 µm in an antiparallel direction, both the donor die and the target die may be adjusted in position to meet at a placement location (where placement of the donor die on the target may occur). For a specific example, the donor die may be adjusted 2.5 µm antiparallel to its offset, for a final offset of 1.5 µm in the first direction, while the target may be adjusted by 2.5 µm antiparallel to its offset, for a final offset of 1.5 µm in the first direction. The placement location may be determined based on the position of the donor die, the position of the target, the range of adjustment available to the donor die, the range of adjustment available to the target, etc. The placement location may be asymmetric (e.g., equidistant between the location of the donor die and the target location) or asymmetric (e.g., closer to one of the location of the donor die or the target location). The placement location may be symmetric in one direction and asymmetric in others. For example, the location of the donor die may be adjusted in the out of plane direction while the target location is not adjusted in the out of plane direction, but both the location of the donor die and the target location may be adjusted in plane.

At an operation 440, the plurality of donor die are placed on the one or more targets. The donor die may be placed on the targets by movement of one or more support stages, such as the first support stage containing the plurality of recesses, a second support stage corresponding to the targets, etc. The donor die may experience self-alignment as the donor die are brought into contact with the targets. For example, the donor die may be biased with respect to the target locations such that electrically active areas of the donor die are attracted to certain areas, such as electrically attractive areas, of the target locations. The plurality of donor die may be adhered to the plurality of target locations. The plurality of donor die may be bonded, such as by annealing, to the plurality of target locations. The plurality of donor die may be released from the plurality of die actuators or from the support structure.

Placement of the plurality of donor die on the targets may occur at a given position of the first stage, such as a position where the plurality of recesses which contain one or more of the plurality of donor die align with the targets. Placement of the plurality of donor die on the targets may occur after adjustment of the locations of the plurality of donor die. Placement of the plurality of donor die on the targets may occur at a given position of the first stage to which the first stage is moved after the plurality of donor die are placed in the recesses, such as by the pick and place element, after the plurality of donor die locations are measured, such as by a location measurement element, and after the locations of the plurality of donor dies are adjusted, such as by die actuators. Placement of the plurality of donor die on the targets may occur at a fourth position of the first stage, while adjustment of the locations of the plurality of donor dies may occur at a third position of the first stage, measurement of the plurality of donor die location may occur at a second position of the first stage and placing of the plurality of donor die within the recesses may occur at a first position of the first stage, where again "first", "second", "third", and "fourth" are relative descriptors.

In some embodiments, an additional set of donor die may be placed on the target. For example, if the targets correspond to targets for a target wafer, the targets acquired for one of the target wafers may be applied to additional target wafers with the same manufacturing parameters. In another example, if multiple die are to be stacked, targets for a second layer stacking may be acquired when the first layer stacking occurs-e.g., donor die locations for a first layer stacking may be used as targets for a second layer stacking.

As described above, method 400 (and/or the other methods and systems described herein) is configured for alignment of multiple die.

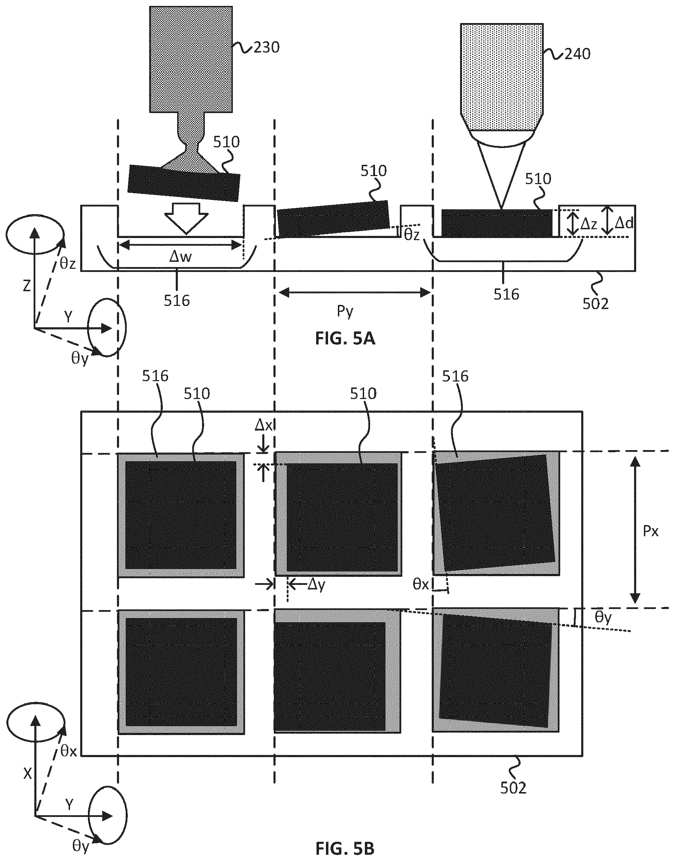

Figures 5A-5B are schematic diagrams illustrating a method of placement of dies in recesses of a moveable stage. Figure 5A depicts a cross-sectional view of placement of dies 510 in recesses 516 on the support stage 502. The dies 510 may be donor dies or target dies. In one embodiment, both donor die and target die may be placed in recesses of corresponding moveable stages, such as the support stage 502. For ease of description, a substantially planar face of the support stage 502 is depicted. It should be understood that the recesses 516 of Figure 5A may correspond to recesses which lie along a longitudinal plane of the support stage 502 (such as corresponding to recess 216A or the donor die 210A in the support stage 202 of Figure 2, corresponding to the target die 220A-220C and corresponding recesses in the support structure 250 of Figure 2, corresponding to the recess 316A or the donor die 310A of the first support stage 302 Figure 3, or corresponding to the recess 366A or the target die 360A of the second support stage 350 of Figure 3). The recesses 516 of Figure 5B may correspond to recesses which lie along multiple longitudinal dimensions of the support stage 502 (such as corresponding to the donor die 210A-210C along the y and z-directions Figure 2). Multiple operations may be depicted as occurring, which may occur at different times or positions of the support stage 502. A frame of reference relative to the die 510 has been chosen for descriptive purposes, but operations can also occur relative to the support stage 502, targets (not depicted), etc.

The die 510 may be any dies suitable for heterogeneous integration (or homogeneous integration). The donor dies 510 may be supported by die actuators within the recesses 516. The die 510 may be placed in the recesses 516 by the pick and place element 230 (such as described in reference to Figure 2), or alternatively by another pick and place element or another method. The die 510 may consist of dies (e.g., donor die or target die) from a single wafer, for multiple wafers of the same type, or from different types of wafers. The die 510 may have substantially the same dimensions or different dimensions, such as a die height, a die width, or a die length. The die 510 may be planarized. The die 510 may each be supported by one or more die actuators. In some embodiments, multiple of the die 510 may each be supported within one recess 516 or by one of the die actuators. In some embodiments, some of the recesses 516 may be empty or otherwise not correspond to one of the die 510. The die 510 may be smaller in dimension than the recesses. The recesses may have the same of different recess dimensions, such as a recess depth, a recess width, and a recess length. The die 510 may be electrostatically or otherwise secured within the recesses 516.

The pick and place element 230 may place the die 510 within the recesses 516 at intended positions. The intended positions may be the same or different for each of the recesses 516. For example, the pick and place element 230 may attempt to place the die 510 within the recesses 516 relative to the intended positions (e.g., as given by periodicity P_{Y} in the Y direction and periodicity P_{X} in the X direction) with respect to the support stage 502. In another example, the pick and place element 230 may attempt to place the die 510 within the recesses 516 with respect to the position of the recesses 516 themselves. The pick and place element 230 may or may not attempt to compensate for irregularities in the placement of the recesses 516 when placing the die 510.

A location measurement element 240 is also shown, which may be the same as the location measurement element 240 as described in relation to Figure 2. The location measurement element 240 may be a camera, e.g., a two-dimensional camera, two or more one-dimensional cameras, an optical camera, etc., or another measurement device. The location measurement element 240 may be made up of multiple location measurement elements, such as an in-plane measurement device which may measure locations in the x-y plane and an out of plane measurement device which may measure locations or distances in the Z direction. The location measurement element 240 may include one or more confocal microscopes, which may measure depth. The location measurement element may measure position, relative or absolute position, using overlay diffraction or other diffraction-based methods. The location measurement element 240 may operate in a scanning mode or from a fixed position relative to the support stage 502.

Figure 5B depicts a plan view of the die 510 within the recesses 516 on the support stage 502. The positions of the die 510 may be described with reference to one or more origin points. For ease of description, the positions of the die 510 are here in described with reference to their intended position (e.g., as given by periodicity Px and periodicity P_{Y} and Δz from Figures 5A-5B). The position of each of the die 510 may be described in free space by six coordinates -Δx and θx along the x-axis, Δy and θy along the y-axis, and Δz and θz along the z-axis (as shown in Figure 5A). The angle θi (where i may be x, y, or z) corresponds to the angle of rotation of the die 510 about the corresponding axis. Because there may be out of plane rotation (e.g., along θz), the angles θz and θy may not be complementary. The positions of the die 510 may be limited by the accuracy and reproducibility of the pick and place element 230, the positions of the recesses 516, and by the regularity of the support stage 502.

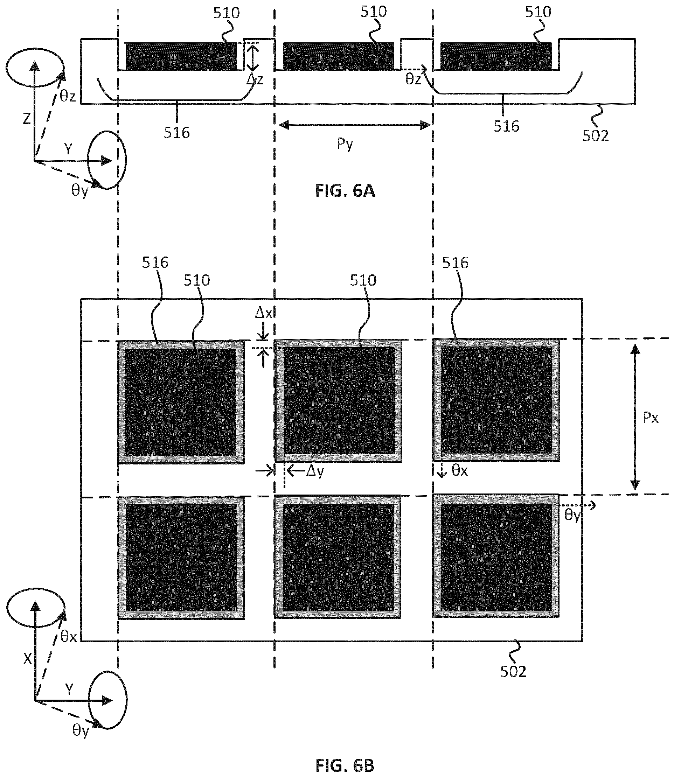

Figures 6A-6B are schematic diagrams illustrating a method of adjusting placement of dies in recesses of a moveable stage. Figure 6A depicts a cross-sectional view of placement of die 510 in the recesses 516 on the support stage 502 after adjustment of the locations of the die 510. The die 510 may be donor die or target die (such as corresponding to recess 216C or die 210C in the support stage 202 of Figure 2, corresponding to the target die 220A-220C and corresponding recesses in the support structure 250 of Figure 2, corresponding to recesses 316C or the donor die 310 C of the first support stage 302 of Figure 3, corresponding to the recesses 316E of the donor die 310E of the first support stage 302 of Figure 3, corresponding to the target die 360C or the recesses 366C of the second support stage 350 of Figure 3). The die 510 may be adjusted (e.g., in position) by any appropriate action, including by die actuators. Die adjustment will be further described with respect to "die adjustment elements", which may be die actuators, may be external elements, such as pick and place elements, etc.

The die adjustment elements may operate in conjunction with the location measurement element 240 (of Figure 5A). The die adjustment elements may incrementally (or iteratively) adjust positions of the die 510 based on or in response to position information acquired by the location measurement element 240 (of Figure 5A). The die adjustment element may also or instead adjust positions of the die 510 based on position information of targets (e.g., the target die positions, target wafer information). The die adjustment elements may attempt to move the die 510 to intended positions (e.g., to compensate for errors in position of the recesses 516, the targets, etc.). In some embodiments, the die adjustment elements may operate in conjunction with die adjustment elements of target to align the die 510 with target die at locations which may not be the intended positions. The die adjustment elements may align the die 510 with or without respect to positions on the support stage 502. The die adjustment elements may additionally or instead adjust positions of the die adjustment elements (e.g., die actuators) themselves in one or more direction.

Figure 6B depicts a plan view of the die 510 placed within the recesses 516 of the support stage 502 after alignment. The positions of the die 510 may be described with reference to one or more origin points. The position of each of the die 510 may be described in free space by six coordinates -Δx and θx along the x-axis (where θx indicates parallelism with the x-axis), Δy and θy along the y-axis (where θy indicates parallelism with the y-axis), and Δz and θz along the z-axis (as shown in Figure 6A) where θz indicates parallelism between the x-y longitudinal planes of the die 510 and the support stage 502. The positions of the die 510 may be limited by the accuracy and reproducibility of die adjustment elements, the extents of the recesses 516, etc. and may still include placement errors, which may be smaller than placement errors possible when using a pick and place element.

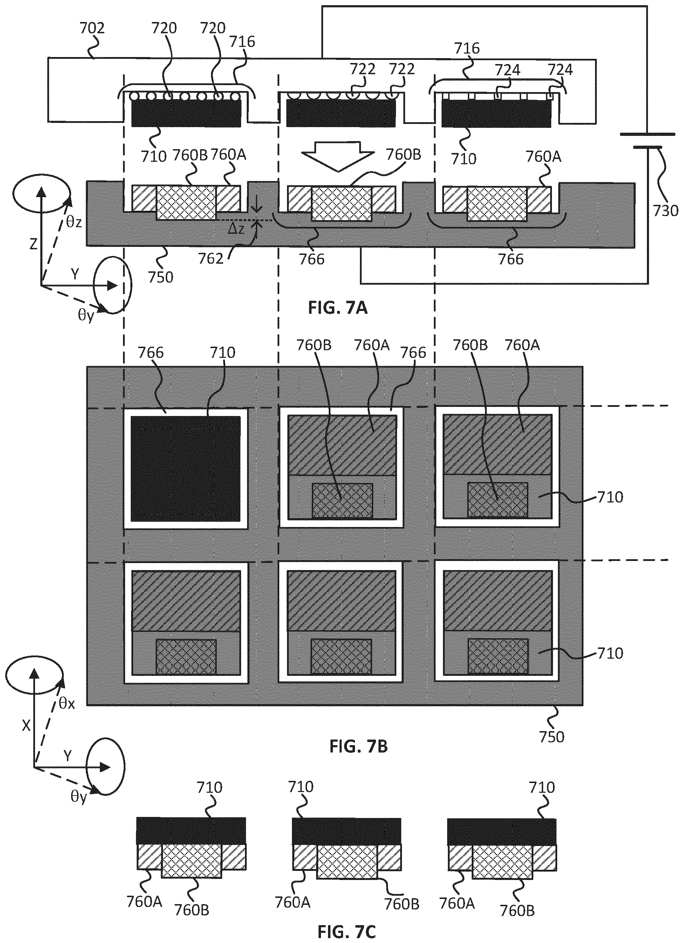

Figures 7A-7C are schematic diagrams illustrating a method of placement of donor dies onto targets by use of recesses in a moveable stage. The descriptors "donor" and "target" are relative, and it should be understood that target items may be placed instead onto donor items. Figures 7A and7C are cross-sectional views of various steps of die placement, while Figure 7B is a planar view of a step of die placement. Figure 7A depicts placement of donor dies 710 in the recesses 716 on the target dies 760A and 760B in the recesses 766, by bringing a support stage 702 (having the recesses 716) and a support stage 750 (having the recesses 766) into proximity. The recesses 766 are depicted as having multiple recess depths, such as a first recess depth corresponding to the target die 760A and a second (deeper) recess depth corresponding to a target die 760B. The difference between the first recess depth and the second recess depth is noted as Δz 762. The recesses 716 and the recesses 766 may have dimensions which correspond to one or more die, where such dimensions may vary (for example, a recess may have a deeper, wider, or longer portion etc. corresponding to a first die than portions corresponding to a second die). The recesses 716 and recesses 766 may instead be multiple recesses, such as separate recesses, adjoining recesses, disjoint recesses, continuous recesses, etc.

In Figure 7A, the support stage 702 is shown as approaching the support stage 750, however the direction of approach is relative, and the support stage 750 may instead or additionally approach the support stage 702. In Figure 7A, the support stage 702 is shown as being rotated (e.g., reflected about the y-axis) relative to the depiction of the support stage 502 of Figure 5A and 6A in order to complement the position of the support stage 750, however either or both the support stage 702 and the support stage 750 may be rotated or translated before approach-such as based on the positions shown in Figures 2-3. The support stage 702 may be aligned (e.g., in the X direction, in the Y direction, in the Z direction, rotationally, etc.) with the support stage 750 based on alignment marks (not depicted), such as alignment marks corresponding to the support stage 702, the support stage 750, the recesses 716, the recesses 766, the donor die 710, the target die 760A, or the target die 760B.

The donor die 710 may experience self-alignment with the target die 760A or the target die 760B. The donor die 710 and the target die 760A and 760B may experience self-alignment due to application of a charge (e.g., voltage), such as supplied by voltage element 730. The voltage element may supply voltage that may oppositely charge corresponding elements of the donor die 710 and the target die 760A and 760B. The corresponding elements may be electrically active areas, such as the electrically active areas 106 and 108 of Figures 1A-1C. The corresponding elements may be elements of the circuitry of the donor die 710 or the target die 760A and 760B. For example, the corresponding elements may be TSVs, which are to be connected. The corresponding elements may be elements which are not part of the circuitry itself, such as metal pads on die edges, or top layer features (such as sacrificial features) which are not integral to circuitry of the die. The self-alignment of the donor die 710 and the target die 760A and 760B may be facilitated by one or more dynamic (e.g., sliding) stages. The dynamic stage may be incorporated into one or more die actuators. The dynamic stage may be comprised of one or more rolling, bending, or otherwise alterable elements such as dynamic elements 720, 722, and 724. The dynamic stage may be incorporated into a die chuck or other die adhesion element, such as an electrostatic clamp. The dynamic stage may be between a die chuck and a die or between a die chuck and a surface of the recesses 716. A dynamic stage may support the donor die 720 or the target die 760A or 760B.

Figure 7B is a planar view of the placement of the donor die 710 on the target die 760A and 760B. In Figure 7B, one of the donor die 710 is depicted as a solid black, corresponding to placement of the donor die 710 on top of the target die 760A and 760B in the z-direction. The others of the donor die 710 are depicted as transparent rectangular shapes, showing the alignment of the donor die 710 with the target die 760A and 760B in the z-direction. The donor die 710 may be larger or smaller than the target die 760A and 760B in any dimension. For example, the donor die 710 is depicted as having the same width as the target die 760A, but a larger width than the target die 760B. Likewise, if the donor die 710 or target is comprise of multiple die (such as the target die 760A and 760B), the multiple die may have different or the same dimensions. For example, the target die 760A is depicted as having a smaller depth than the target die 760B (in Figure 7A) and a larger width than the target die 760B.

The alignment of the donor die 710 and the target die 760A and 760B may be accurate to within 200 nm. The alignment of the donor die 710 and the target die 760A and 760B when supported by the recesses 716 or the recesses 766 may be more accurate than can be accomplished by pick and place alone. The placement of the donor die 710 on the target die 760A and 760B when supported by the recesses 716 and the recesses 766 may additionally (or instead) be faster than placement by a die bonder. The placement of the donor die 710 on the target die 760A and 760B when supported by the recesses 716 and the recesses 766 may provide die placement for various dies which are not whole wafers, e.g., for diced wafers which cannot be placed, aligned, or bonded by wafer bonders which may require that the donor die 710 and a target die (e.g., either the target die 760A or the target die 760B) have the same dimensions (e.g., which may be most useful for homogeneous integration).

Figure 7C depicts removal of the support stage 702 and the support stage 750 after the donor die 710 are adhered to the target dies 760A and 760B. Contact of the donor dies 710 with the target dies 760A and 760B may include adhesion (e.g., electrostatic adhesion, van der Waals attraction, etc.) or annealing of the donor dies 710 the target dies 760A and 760B. After the donor dies 710 are adhered to the target dies 760A and 760B, the donor dies 710 may be released, including electrostatically, from the recesses 716 of the support stage 702. The release may include active disengagement, for example electrostatic repelling between the recesses 716 and the donor dies 710. After the donor dies 710 are released from the recesses 716, the support stage 702 may be moved to separate the recesses 716 and the donor die 710. The removal of the support stage 702 may occur along the Z direction but may be instead or additionally in another direction. In some embodiments the removal of the support stage 702 may include deconstruction or breaking apart of the support stage 702.

The donor dies 710 and the target dies 760A and 760B (which may be connected to the donor dies 710) may be supported by the support stage 750. As described in reference to the release of the donor die 710 from the recesses 716 and the support stage 702, the target die 760A and 760B may be actively or passively released from the recesses 766 and the support stage 750. Upon release, the donor die 710 and the target die 760A and 760B may be supported by another structure (not depicted), for example a collection receptacle, a chip feeder line, etc. The donor die 710 and the target die 760A and 760B may be annealed or otherwise electrically, physically, chemically, etc. joined before or after removal of the support stage 702 (or removal of the support stage 750). The donor die 710 and the target die 760A and 760B, once joined, may function as a single unit, e.g., of circuitry. The donor die 710 and the target die 760A and 760B may be further processed, such as via lithography, may be further analyzed, such as via electrical testing, may be further diced, may be further integrated including with additional die (e.g., such as additional donor die 710, additional target die 760A, additional target die 760B, additional die of a different type, etc.), may be packaged, etc.

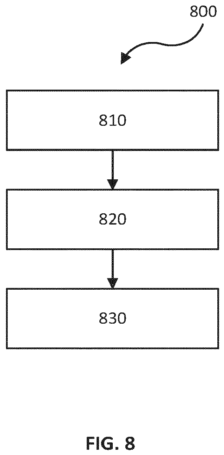

Figure 8 is a flowchart which illustrates a method of die adjustment. Each of these operations is described in detail below. The operations of method 800 presented below are intended to be illustrative. In some embodiments, method 800 may be accomplished with one or more additional operations not described, and/or without one or more of the operations discussed. Additionally, the order in which the operations of method 800 are illustrated in Figure 8 and described below is not intended to be limiting. In some embodiments, one or more portions of method 800 may be implemented (e.g., by simulation, modeling, etc.) in one or more processing devices (e.g., one or more processors). The one or more processing devices may include one or more devices executing some or all of the operations of method 800 in response to instructions stored electronically on an electronic storage medium. The one or more processing devices may include one or more devices configured through hardware, firmware, and/or software to be specifically designed for execution of one or more of the operations of method 800, for example.

At an operation 810, a donor die is placed in a recess. The donor die may be placed in the recess by a pick and place element, such as the pick and place element 230 described in reference to Figure 2. The donor die placement in the recess may be monitored, such as by the pick and place element, such that if the donor die is not placed completely within the recess, the donor die may be replaced (e.g., repositioned, discarded, etc.). The recess may be located within a moveable stage. The recess may be on the order of the size of the donor die while also being larger than the donor die. The recess may have one or multiple recess widths, recess depths, recess lengths, etc. The donor die may be multiple die, such as previously joined die (e.g., two or more stacked die), or discrete die (such as depicted for the target die 760A and 760B of Figure 7A-7C).

At an operation 820, a donor die location is obtained. The donor die location may be obtained using any appropriate method, including those methods previously described in reference to the operation 420 of Figure 4. The donor die location may be measured or may be obtained from storage.

A target location corresponding to a target of the donor die may also be obtained. The target may be obtained using any appropriate method, including those methods previously described in reference to the operation 430 of Figure 4. The target may be measured or may be obtained from storage. The target corresponding to a donor die may be identified from a plurality of targets.

In some embodiments, the donor die location and the target may be obtained in the opposite order-the order of operations provided herein are for illustration only and should not be taken as limiting. In some embodiments, an intended donor die location is determined based on the target. For example, a corresponding location for the donor die (i.e., an intended donor die location) may be determined based on a difference between an ideal and actual target. In some embodiments, a difference between the donor die location and the intended donor die location may be determined. The difference may be determined with respect to one or more direction, such as with respect to up to six degrees of freedom. The difference between the intended donor die location and the donor die location may be used to determine adjustment factors in as many as six degrees of freedom, where adjustment factors may be distances, angles of rotation, etc.

At an operation 830, the location of donor die is adjusted. The location of the donor die may be adjusted by piezoelectric or other actuators. The locations of the donor die may be adjusted by applying electrical actuation (or other actuation) to one or more support to lengthen or shorten the support, where the support is a support of a die chuck, the die, the recess, etc. The location of the donor die may be adjusted by applying electrical actuation to feet of one or more support (such as via a piezoelectric microstepper) to move the base the one or more support in one or more direction at a time. The location of the donor die may be adjusted based on the donor die location, the target, the relationship between the donor die location and the target, etc. The location of the donor die may be adjusted using any appropriate method. In some embodiments, the location of the donor die may be measured (or otherwise obtained) after adjustment. The location of the donor die may be iteratively measured and adjusted (as previously discussed in reference to Figure 3). In some embodiments, the location of the donor die may be tracked as a function of adjustment, such as to determine drift of one or more adjustment actuators or to improve future adjustments.

As described above, method 800 (and/or the other methods and systems described herein) is configured for positional adjustment of die.

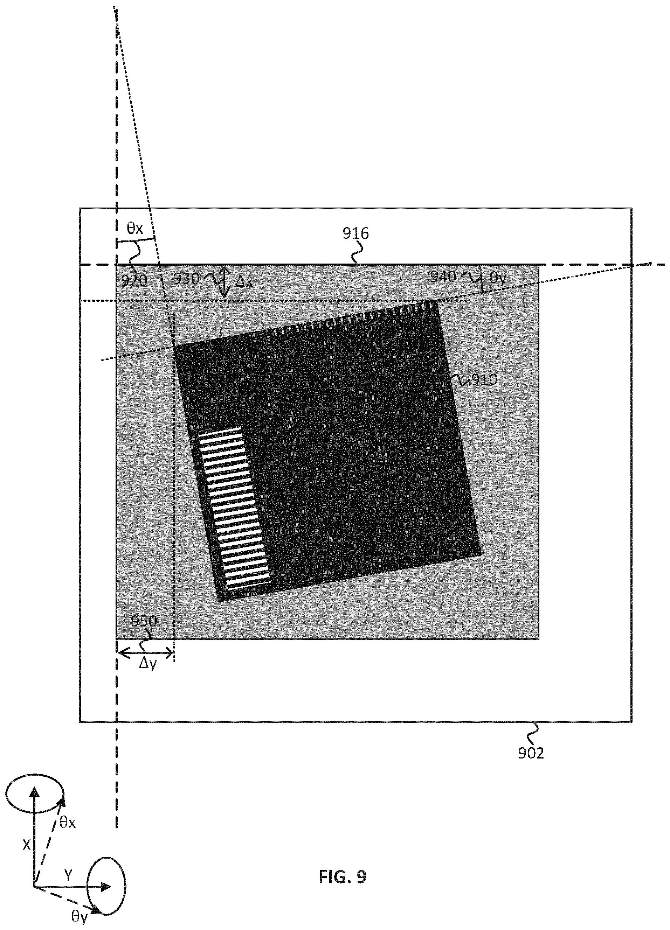

Figure 9 is a schematic diagram illustrating a method of die location measurement using two-dimensional images. Figure 9 is a plane view of a donor die 910 is a recess 916 of a support stage 902 (only a portion of which is shown). Figure 9 is described in relation to a donor die 910, but the donor die 910 may instead be a target die. The location of both the donor die 910 and a corresponding target die may be determined, including with respect to relative recesses (e.g., the recess 916 and a recess corresponding to the target die). The location of the donor die 910 may be determined based on a two-dimensional image of the recess 916 or of the support stage 902 including the recess 916. The location of the donor die 910 may be determined with respect to four directions in-plane, such as with respect to an angle of rotation 920 with respect to the x-axis, an x displacement 930, an angle of rotation 940 with respect to the y-axis, and a y displacement 950. The x displacement 930 and the y displacement 950 may correspond to a smallest displacement (e.g., a offset between an axis and the closest approach of a die), a largest displacement, a displacement between two points (e.g., between a center of the recess 916 along an axis and the center of the donor die 910 along the side corresponding to the axis), etc. The angle of rotation 920 and the angle of rotation 940 may correspond to an angle of rotation between an axis and a one-dimensional feature (e.g., line, side, edge, linear alignment mark, etc.) of the donor die 910. The angle of rotation 920 and the angle of rotation 940 may also correspond to an angle given by identification of three of more points or one-dimensional features, such as points on the corresponding axis and points on the donor die 910, such as corners, features, alignment marks, etc. The angle of rotation 920 and the angle of rotation 940, the x displacement 930, and the y displacement 950 may be determined based on identification of one or more features (e.g., corner, side, midpoint, alignment mark, etc.) of the donor die 910. The angle of rotation 920 and the angle of rotation 940, the x displacement 930, and the y displacement 950 may be determined based on the identification of one or more features of the recess (e.g., corner, side, midpoint, alignment mark, etc.) of the recess 916. The angle of rotation 920 and the angle of rotation 940, the x displacement 930, and the y displacement 950 may be determined by comparison of features of the donor die 910 and the recess 916. Features of the recess 916 and the donor die 910 may be identified by any appropriate image recognition method. Features of the donor die 910 may include topside alignment marks (depicted as white rectangles). Features of the donor die 910 may include edge alignment marks (depicted as voids). Feature of the donor die 910 may include electrically active areas or other topside features.

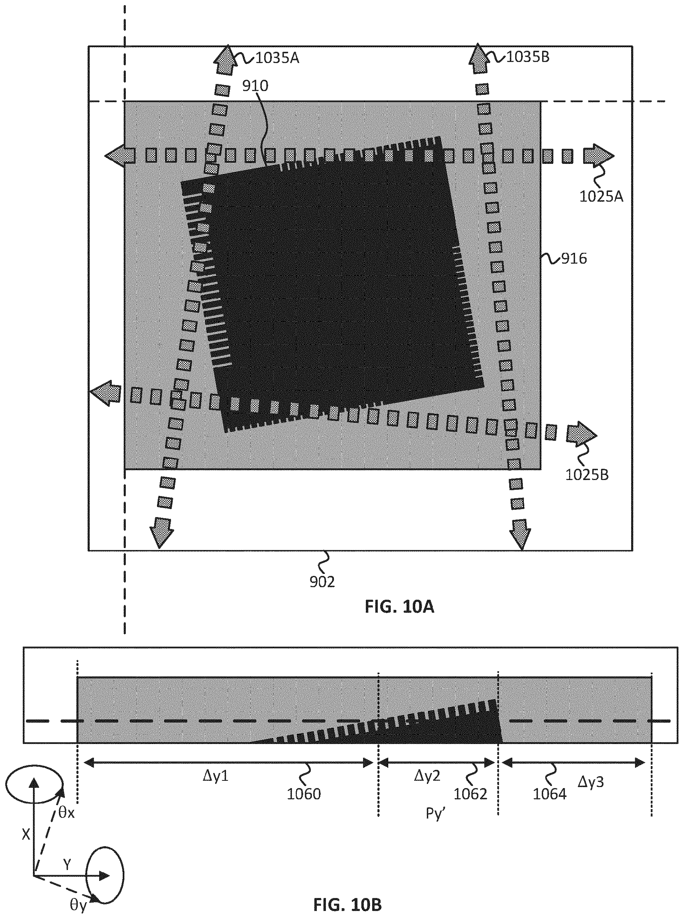

Figures 10A-10B are schematic diagrams illustrating a method of die location measurement using one-dimensional images. Figure 10A is a plan view of a donor die 910 is a recess 916 of a support stage 902 (only a portion of which is shown). Figures 10A-10B are described in relation to a donor die 910, as in Figure 9, the donor die 910 may instead be a target die. The location of both the donor die 910 and a corresponding target die may be determined, including with respect to relative recesses (e.g., the recess 916 and a recess corresponding to the target die). The location of the donor die 910 may be determined based on multiple one-dimensional images of the recess 916 or of the support stage 902 including the recess 916. The location of the donor die 910 may be determined with respect to four directions in-plane, such as with respect to an angle of rotation 920 with respect to the x-axis, an x displacement 930, an angle of rotation 940 with respect to the y-axis, and a y displacement 950 as depicted in Figure 9. The location of the donor die 910 may be determined based on multiple one-dimensional images, taken at known or determined positions with respect to the donor die 910 and the recess 916. Example directions of the multiple one-dimensional images are shown, including horizonal directions 1025A and 1025B and vertical directions 1035A and 1035B. The horizontal directions 1025A and 1025B are provided by way of example, and it should be understood that one or more one-dimensional images may be obtained at various angles to the horizontal axis, such as substantially horizontal, at an acute angle to the horizontal axis, at a positive angle to the horizontal axis, at a negative angle to a horizontal axis, etc. Likewise, the vertical directions 1035A and 1035B are provided by way of example, and it should be understood that one or more one-dimensional images may be obtained at various angles to the vertical axis, such as substantially vertical, at an acute angle to the vertical axis, at a positive angle to the vertical axis, at a negative angle to a vertical axis, etc. where "horizontal", "vertical", "positive", and "negative" may be relative descriptors with respect to any appropriate reference frame. The horizontal directions 1025A and 1025B and the vertical directions 1035A and 1035B may be purposefully angled with respect to the axes (e.g., sides) of the recess 916 in order to improve ability of the one-dimensional images to capture information about offset of the donor die 910 (e.g., with respect to an intended position) or rotation (e.g., with respect to the sides of the recess 916) By determining the relationship between the extents of the donor die 910 and the extends of the recess 916 along the multiple one-dimensional directions, the position of the donor die 910 may be determined.

Figure 10B is a plan view of a one-dimensional (or quasi-one-dimensional) image corresponding to the horizonal direction 1025A. From the one-dimensional image, a distance between the extents of the recess 916 and the extents of the donor die 910 can be determined for each side of the donor die (e.g., y distance 1060 and y distance 1064). If the donor die 910 is not detected in the one-dimensional image, the absence also provides information about the position of the donor die 910 with respect to the recess 916. A distance of projection 1062 of the donor die along the horizonal direction 1025A can also be determined. Based on the distances along the horizontal direction 1025A and distances along at least one other direction (e.g.., the horizontal direction 1025B, the vertical direction 1035A or 1035B, etc.) the position of the donor die 910 within the recess 916 may be determined. Multiple one-dimensional images may be used in order to better characterize the position of the donor die 910, including to account for out of plane rotation and displacement.

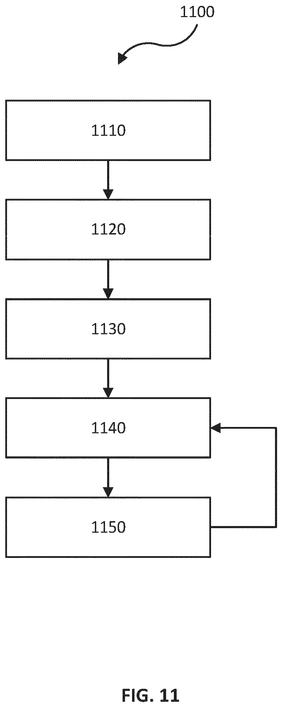

Figure 11 is a flowchart which illustrates a method of die location determination. Each of these operations is described in detail below. The operations of method 1100 presented below are intended to be illustrative. In some embodiments, method 1100 may be accomplished with one or more additional operations not described, and/or without one or more of the operations discussed. Additionally, the order in which the operations of method 1100 are illustrated in Figure 11 and described below is not intended to be limiting. In some embodiments, one or more portions of method 1100 may be implemented (e.g., by simulation, modeling, etc.) in one or more processing devices (e.g., one or more processors). The one or more processing devices may include one or more devices executing some or all of the operations of method 1100 in response to instructions stored electronically on an electronic storage medium. The one or more processing devices may include one or more devices configured through hardware, firmware, and/or software to be specifically designed for execution of one or more of the operations of method 1100, for example.

At an operation 1110, an image of a donor die is acquired. The image may be a two-dimensional image. The image may be two or more one-dimensional images. The image may include out of plane measurements, such as measurements of distance or angle of displacement in an out of plane direction. The image of the donor die may be acquired by a camera. The image of the donor die may be acquired by a photodetector. The image of the donor die may be acquired in black and white, grayscale, full color, etc. The image of the donor die may be acquired by illuminating the donor die with full color light, laser light, infrared light, etc.

At an operation 1120, the image of the donor die is referenced to a corresponding recess. The image of the donor die may be reference instead or additionally to a support structure containing the recess. The image of the donor die may include an image of the corresponding recess or support structure. The image of the donor die may have a known relationship to the recess or support structure.

At an operation 1130, features of the donor die are identified in the image. The features may include a corner of the donor die, a side of the donor die, a topside feature of the donor die. The features may include identification of an alignment mark (such as on the top side or edge of the donor die). The features may include identification of an angle of rotation or periodicity of a feature, for example, a period of a topside grating in one-dimension. Feature of the recess or support structure may also be (or instead) be identified in the image. The features may include a corner of the recess, a side of the recess, a feature (such as an engraved pattern) of the recess. The features may include identification of an alignment mark of the recess or support structure, or other reference feature.

At an operation 1140, a relationship between the features of the donor die and the corresponding recess is determined. The relationship may instead or additionally be determined between the features of the donor die and the support structure. The relationship may be an offset, such as in one or two dimensions, the relationship may be an extent, the relationship may be a point of closes approach, the relationship may be a vector (such as a displacement vector), the relationship may be an angle, etc. The relationship may be determined between any two appropriate points, such as corners, center points, etc. The relationship may be determined relatively or absolutely. The relationship may be determined as a function of one or more variables (e.g., unknowns). Multiple relationships may be determined.

At an operation 1150, the position of the donor die may be determined based on one or more relationship between the features of the donor die and the recess, or between the donor die and the support structure. If the relationship does not yield an absolute position, such as a relationship that instead provides a geometric relationship with two variables, another relationship may be determined. Multiple relationships may be used to solve for absolute position of the donor die with respect to the corresponding recess or support structure.

As described above, method 1100 (and/or the other methods and systems described herein) is configured for positional adjustment of die.

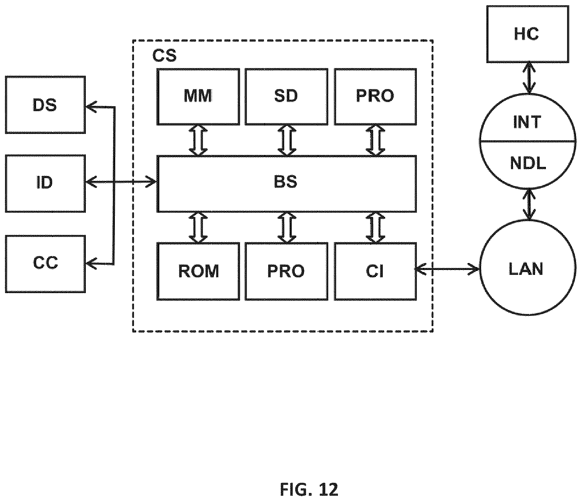

Figure 12 is a diagram of an example computer system CS that may be used for one or more of the operations described herein. Computer system CS includes a bus BS or other communication mechanism for communicating information, and a processor PRO (or multiple processors) coupled with bus BS for processing information. Computer system CS also includes a main memory MM, such as a random-access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, portions of one or more methods described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform the process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" and/or "machine readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

Embodiments of the disclosure are defined in the following numbered clauses:
Clause 1: an apparatus for die placement comprising:
   a first stage comprising a plurality of recesses, the plurality of recesses configured to accept a plurality of donor dies;
   a second stage comprising a support for one or more targets; and
   a measurement system, functionally coupled to the first stage, and configured to:
      obtain locations of the plurality of donor dies in the plurality of recesses of the first stage, and
      based at least on the obtained locations, provide output signals to
      adjust the locations of the plurality of donor dies supported by the first stage to correspond to locations of the one or more targets, and
      based at least in part on the adjusted locations, provide output signals to
      place the plurality of donor dies on the one or more targets supported by the second stage by relative movement between the first stage and the second stage.
Clause 2: the apparatus of clause 1,
   wherein adjustable stages are disposed within the plurality of recesses, the adjustable stages configured to support the plurality of donor dies; and
   wherein the measurement system is further configured to provide output signals to adjust the locations of the plurality of donor dies using the adjustable stages supporting the plurality of donor dies.
Clause 3: the apparatus of clause 2, wherein the measurement system is further configured to provide output signals to one or more actuators to adjust location of one or more supports of the adjustable stages.
Clause 4: the apparatus of clause 2, wherein output signals to adjust the locations of the plurality of donor dies comprise output signals to piezoelectric activations which adjust locations of supports of the adjustable stages.
Clause 5: the apparatus of clause 2, wherein the adjustable stages are adjustable with respect to at least three degrees of freedom.
Clause 6: the apparatus of clause 2, wherein the adjustable stages are adjustable with respect to six degrees of freedom.
Clause 7: the apparatus of clause 1, the measurement system further comprising:
   an imaging device, configured to obtain images of the plurality of donor dies in the plurality of recesses; and
   a processor in communication with the imaging device and configured to determine the locations of the plurality of donor dies in the plurality of recesses based on the images of the plurality of donor dies in the plurality of recesses.
Clause 8: the apparatus of clause 7, wherein the imaging device comprises at least one photodetector configured to obtain two-dimensional images of the plurality of donor dies,
   the processor further configured to cooperate with the at least one photodetector to:
   detect features comprising at least one of an edge of a donor die, a corner of the donor die, an edge of a recess, a corner of a recess, a gap between the edge of a donor die and the edge of a recess, an angle of orientation of an edge of a donor die, and an angle of orientation of a surface of a donor die for the plurality of donor dies in the two-dimensional images; and
   determine the locations of the plurality of donor dies in the plurality of recesses based on the detected features.
Clause 9: the apparatus of clause 7, wherein the imaging device comprises at least two photodetectors configured to obtain one-dimensional images of the plurality of donor dies,
   the processor further configured to cooperate with the photodetectors to:
   detect features comprising at least one of an edge feature of a donor die, a top feature of a donor die, an edge of a recess, an angle of orientation of an edge of a donor die, and an angle of orientation of a top feature of a donor die; and
   determine the locations of the plurality of donor dies in the plurality of recesses based on the detected features.
Clause 10: the apparatus of clause 1, the measurement system further configured to:
   obtain locations of the one or more targets, and
   provide output signals to
   adjust the locations of the plurality of donor dies supported by the first stage to correspond to the obtained locations of the one or more targets.
Clause 11: the apparatus of clause 1, wherein output signals to adjust the locations of the plurality of donor dies supported by the first stage to corresponding to location of the one or more targets comprise:
   output signals to adjust the locations of the plurality of donor dies supported by the first stage to correspond to placement locations based on the obtained locations; and
   output signals to adjust the locations of the one or more targets supported by the second stage to correspond to the placement locations based on the locations of the one or more targets; and
   wherein output signals to place the plurality of donor dies on the one or more targets comprise output signals to place the plurality of donor dies on the one or more targets at the placement locations.
Clause 12: the apparatus of clause 11, the measurement system further configured to:
   determine the placement locations based on the obtained locations of the plurality of donor dies and the locations of the one or more targets.
Clause 13: the apparatus of clause 1, wherein:
   electrostatic clamps are disposed within the plurality of recesses, controllable by the measurement system, the electrostatic clamps configured to hold the plurality of donor dies within the plurality of recesses,
   wherein the measurement system is further configured to provide output signals to release, at least in part, the electrostatic clamps holding the plurality of donor dies within the plurality of recesses as the plurality of donor dies are placed on the one or more targets by relative movement between the first stage and the second stage.
Clause 14: the apparatus of clause 1, further comprising:
   a voltage source,
   wherein the measurement system is further configured to provide output signals to the voltage source to cause alignment of the plurality of donor dies and the one or more targets as the plurality of donor dies are placed on the one or more targets by relative movement between the first stage and the second stage.
Clause 15: the apparatus of clause 14, wherein the measurement system is further configured to provide output signals to the voltage source to provide a plurality of voltages to the plurality of donor dies, a given voltage of the plurality of voltages provided to a given donor die to the plurality of donor dies to cause alignment of the given donor die and the one or more targets.
Clause 16: the apparatus of clause 1, further comprising:
   a dynamic stage interposed between each of the plurality of recesses and each of the plurality of donor dies, the dynamic stage allowing at least one of translation and rotation of each of the plurality of donor dies during alignment of the plurality of donor dies and the one or more targets.
Clause 17: the apparatus of clause 16, wherein the dynamic stage comprises rollers.
Clause 18: the apparatus of clause 1, wherein the first stage is at least one of rotatable about a longitudinal axis, and translatable about a longitudinal axis.
Clause 19: the apparatus of clause 1, wherein the second stage is at least one of translatable about a longitudinal plane, and rotatable about a longitudinal axis.
Clause 20: the apparatus of clause 1, wherein the first stage is a moveable stage and the second stage is a stationary stage.
Clause 21: The apparatus of clause 1, further comprising:
   a pick and place tool, functionally coupled to the measurement system, configured to place donor dies within the plurality of recesses,
   wherein the measurement system is further configured to provide output signals to control the pick and place tool to place the plurality of donor dies within the plurality of recesses.
Clause 22: the apparatus of clause 1, further comprising:
   a bonding tool, configured to bond the plurality of donor dies to the one or more targets.
Clause 23: a method for die placement comprising:
   placing a plurality of donor dies into a plurality of recesses in a first stage, the first stage being in a first position relative to a second stage;
   measuring locations of the plurality of donor dies in the plurality of recesses;
   adjusting the locations of the plurality of donor dies within the plurality of recesses to correspond to a plurality of target locations, the plurality of target locations corresponding to a second stage; and
   placing the plurality of donor dies onto the plurality of target locations, the first stage being in a second position relative to the second stage, the first position being different than the second position.
Clause 24: the method of clause 23, wherein measuring the locations of the plurality of donor dies comprises measuring the locations of the plurality of donor dies by optical metrology.
Clause 25: the method of clause 23, wherein adjusting the locations of the plurality of donor dies comprises adjusting the locations of the plurality of donor dies by adjusting adjustable stages within the plurality of recesses, the adjustable stages configured to support the plurality of donor dies within the plurality of recesses.
Clause 26: the method of clause 23, wherein placing the plurality of donor dies onto the plurality of target locations comprises:
   applying a voltage, using a voltage source, between the plurality of donor dies and the plurality of target locations, the voltage configured to cause alignment of the plurality of donor dies and the plurality of target locations; and
   releasing, at least partially, an electrostatic clamping force holding the plurality of donor dies within the plurality of recesses as the first stage and the second stage approach.
Clause 27: the method of clause 26, wherein the electrostatic clamping force is released such that the plurality of donor dies align with the plurality of target locations due to the applied voltage.
Clause 28: the method of clause 27, wherein applying the voltage comprise applying a plurality of voltages between the plurality of donor dies and the plurality of target locations, a given of the plurality of voltages configured to cause alignment between a given of the plurality of donor dies and a given of the plurality of target locations.
Clause 29: the method of clause 23, wherein adjusting the locations of the plurality of donor dies within the plurality of recesses to correspond to a plurality of target locations comprises:
   measuring the plurality of target locations; and
   adjusting the locations of the plurality of donor dies to correspond to the measured plurality of target locations.
Clause 30: the method of clause 23, wherein adjusting the locations of the plurality of donor dies within the plurality of recesses to correspond to a plurality of target locations comprises:
   adjusting the locations of the plurality of donor dies to correspond to a plurality of placement locations; and
   adjusting the plurality of target locations to correspond to the plurality of placement locations, and
   wherein placing the plurality of donor dies onto the plurality of target locations comprises placing the plurality of donor dies onto the adjusted plurality of target locations at the plurality of placement locations.
Clause 31: the method of clause 30, further comprising determining the plurality of placement locations based on the locations of the plurality of donor die and the plurality of target locations.
Clause 32: the method of clause 23, wherein placing the plurality of donor dies onto the plurality of target locations further comprises aligning the first stage with the second stage by adjusting a position of at least one of the first stage and the second stage.
Clause 33: the method of clause 23, wherein measuring of the locations of the plurality of donor dies in the plurality of recesses comprises measuring the locations of the plurality of donor dies in the plurality of recesses while the first stage is in a third position relative to the second stage.
Clause 34: the method of clause 23, wherein adjusting the locations of the plurality of donor dies within the plurality of recesses comprises adjusting the locations of the plurality of donor dies while the first stage is in a fourth position relative to the second stage.
Clause 35: the method of clause 23, the first stage comprising multiple sets of recesses, wherein, when the first stage is in the first position, a first set of recesses is configured to accept a first plurality of donor dies and a second set of recesses is configured to allow optical measurement of the locations of a second plurality of donor dies.
Clause 36: the method of clause 35, wherein, when the first stage is in the first position, a third set of recesses is configured to place a third plurality of donor dies onto the plurality of target locations. Clause 37: a die placement tool configured to perform the method of any one of clauses 23 to 36

While the concepts disclosed herein may be used for manufacturing with a substrate such as a silicon wafer, it shall be understood that the disclosed concepts may be used with any type of manufacturing system (e.g., those used for manufacturing on substrates other than silicon wafers).

In addition, the combination and sub-combinations of disclosed elements may comprise separate embodiments. For example, one or more of the operations described above may be included in separate embodiments, or they may be included together in the same embodiment.

The descriptions above are intended to be illustrative, not limiting. Thus, it will be apparent to one skilled in the art that modifications may be made as described without departing from the scope of the claims set out below.

## Claims

1. An apparatus for die placement comprising:
a first stage comprising a plurality of recesses, the plurality of recesses configured to accept a plurality of donor dies;
a second stage comprising a support for one or more targets; and
a measurement system, functionally coupled to the first stage, and configured to:
obtain locations of the plurality of donor dies in the plurality of recesses of the first stage, and
based at least on the obtained locations, provide output signals to adjust the locations of the plurality of donor dies supported by the first stage to correspond to locations of the one or more targets, and
based at least in part on the adjusted locations, provide output signals to
place the plurality of donor dies on the one or more targets supported by the second stage by relative movement between the first stage and the second stage.

2. The apparatus of claim 1,
wherein adjustable stages are disposed within the plurality of recesses, the adjustable stages configured to support the plurality of donor dies; and
wherein the measurement system is further configured to provide output signals to adjust the locations of the plurality of donor dies using the adjustable stages supporting the plurality of donor dies.

3. The apparatus of claim 2, wherein the measurement system is further configured to provide output signals to one or more actuators to adjust location of one or more supports of the adjustable stages.

4. The apparatus of claim 2, wherein output signals to adjust the locations of the plurality of donor dies comprise output signals to piezoelectric activations which adjust locations of supports of the adjustable stages.

5. The apparatus of claim 2, wherein the adjustable stages are adjustable with respect to six degrees of freedom.

6. The apparatus of claim 1, the measurement system further comprising:
an imaging device, configured to obtain images of the plurality of donor dies in the plurality of recesses; and
a processor in communication with the imaging device and configured to determine the locations of the plurality of donor dies in the plurality of recesses based on the images of the plurality of donor dies in the plurality of recesses.

7. The apparatus of claim 6, wherein the imaging device comprises at least one photodetector configured to obtain two-dimensional images of the plurality of donor dies,
the processor further configured to cooperate with the at least one photodetector to:
detect features comprising at least one of an edge of a donor die, a corner of the donor die, an edge of a recess, a corner of a recess, a gap between the edge of a donor die and the edge of a recess, an angle of orientation of an edge of a donor die, and an angle of orientation of a surface of a donor die for the plurality of donor dies in the two-dimensional images; and
determine the locations of the plurality of donor dies in the plurality of recesses based on the detected features.

8. The apparatus of claim 6, wherein the imaging device comprises at least two photodetectors configured to obtain one-dimensional images of the plurality of donor dies,
the processor further configured to cooperate with the photodetectors to:
detect features comprising at least one of an edge feature of a donor die, a top feature of a donor die, an edge of a recess, an angle of orientation of an edge of a donor die, and an angle of orientation of a top feature of a donor die; and determine the locations of the plurality of donor dies in the plurality of recesses based on the detected features.

9. The apparatus of claim 1, the measurement system further configured to:
obtain locations of the one or more targets, and
provide output signals to
adjust the locations of the plurality of donor dies supported by the first stage to correspond to the obtained locations of the one or more targets.

10. The apparatus of claim 1, wherein output signals to adjust the locations of the plurality of donor dies supported by the first stage to corresponding to location of the one or more targets comprise:
output signals to adjust the locations of the plurality of donor dies supported by the first stage to correspond to placement locations based on the obtained locations; and
output signals to adjust the locations of the one or more targets supported by the second stage to correspond to the placement locations based on the locations of the one or more targets; and
wherein output signals to place the plurality of donor dies on the one or more targets comprise output signals to place the plurality of donor dies on the one or more targets at the placement locations.

11. The apparatus of claim 10, the measurement system further configured to:
determine the placement locations based on the obtained locations of the plurality of donor dies and the locations of the one or more targets.

12. The apparatus of claim 1, wherein:
electrostatic clamps are disposed within the plurality of recesses, controllable by the measurement system, the electrostatic clamps configured to hold the plurality of donor dies within the plurality of recesses,
wherein the measurement system is further configured to provide output signals to release, at least in part, the electrostatic clamps holding the plurality of donor dies within the plurality of recesses as the plurality of donor dies are placed on the one or more targets by relative movement between the first stage and the second stage.

13. The apparatus of claim 1, further comprising:
a dynamic stage interposed between each of the plurality of recesses and each of the plurality of donor dies, the dynamic stage allowing at least one of translation and rotation of each of the plurality of donor dies during alignment of the plurality of donor dies and the one or more targets.

14. The apparatus of claim 1, further comprising:
a pick and place tool, functionally coupled to the measurement system, configured to place donor dies within the plurality of recesses,
wherein the measurement system is further configured to provide output signals to control the pick and place tool to place the plurality of donor dies within the plurality of recesses.

15. A method for die placement comprising:
placing a plurality of donor dies into a plurality of recesses in a first stage, the first stage being in a first position relative to a second stage;
measuring locations of the plurality of donor dies in the plurality of recesses;
adjusting the locations of the plurality of donor dies within the plurality of recesses to correspond to a plurality of target locations, the plurality of target locations corresponding to a second stage; and
placing the plurality of donor dies onto the plurality of target locations, the first stage being in a second position relative to the second stage, the first position being different than the second position.
